# FASCICULE DE BREVET EUROPEEN

(11) **EP 2 584 878 B1**
(45) Date de publication et mention de la délivrance du brevet: **09.04.2014**
(21) Numéro de dépôt: 12183235.6
(22) Date de dépôt: 05.09.2012
(51) Int. Cl.: H05K 1/16, H05K 1/02, G01R 33/04, G01R 33/00, G01R 33/05, H01F 5/00, H01F 17/00, H01F 27/28, H02K 3/26, H02K 35/02, H05K 3/46

(54) **Circuit imprimé contenant deux bobines, capteur de champ magnétique et générateur de tension alternative**
Gedruckter Schaltkreis, der zwei Spulen enthält, Magnetfeldsensor und Wechselspannungsgenerator
Printed circuit board containing two coils, magnetic field sensor and alternative tension generator

(30) Priorité: 07.09.2011 FR 1157934
(43) Date de publication de la demande: 24.04.2013
(73) Titulaire: Commissariat à l'Énergie Atomique et aux Énergies Alternatives, 75015 Paris (FR)
(72) Inventeur: Klein, Philippe, 38830 Saint Pierre d'Allevard (FR)
(74) Mandataire: Colombo, Michel

(56) Documents cités:
- GB-A- 2 265 013
- GB-A- 2 339 294
- US-A1- 2006 001 422

## Description

L'invention concerne un circuit imprimé, un capteur de champ magnétique et un générateur de tension alternative.

Un circuit imprimé, également plus connu sous l'acronyme PCB (Printed Circuit Board), est un support permettant de relier électriquement un ensemble de composants électriques. Un tel circuit imprimé se présente généralement sous la forme d'une plaque stratifiée. Ce circuit imprimé peut être monocouche ou multicouche. Un circuit imprimé monocouche ne comporte qu'une seule couche de métallisation dans laquelle sont imprimées des pistes conductrices qui raccordent électriquement les différents composants électriques entre eux. Un circuit imprimé multicouche comporte, au contraire, plusieurs couches de métallisation c'est-à-dire au moins deux couches et, de préférence, plus de quatre ou six couches. Dans la suite de cette description, on s'intéresse principalement à ces circuits imprimés multicouches.

Une couche de métallisation est l'une des couches de la plaque stratifiée formant le circuit imprimé dans laquelle sont réalisées une ou plusieurs pistes conductrices qui raccordent électriquement les différents composants électriques entre eux. Cette couche est plane et s'étend parallèlement au plan de la plaque stratifiée. Généralement, la couche de métallisation est obtenue en déposant une couche uniforme d'un matériau conducteur, typiquement un métal tel que du cuivre, puis en gravant cette couche uniforme pour ne laisser subsister que les pistes conductrices.

Les différentes couches de métallisation du circuit imprimé sont espacées mécaniquement les unes des autres par des couches isolantes en matériau électriquement isolant. Ce matériau isolant présente une rigidité diélectrique élevée c'est-à-dire typiquement supérieure à 3 MV/m et, de préférence, supérieure à 10 MV/m. Par exemple, le matériau électriquement isolant est réalisé à partir de résine époxyde et/ou de fibre de verre. La couche isolante se présente généralement sous la forme d'une plaque rigide réalisée dans un matériau qui ne devient pas visqueux lors de son assemblage avec d'autres couches. Par exemple, elle est réalisée à partir d'une résine thermodurcissable qui a déjà subi un thermodurcissement irréversible.

Les différentes couches du circuit imprimé multicouche sont assemblées les unes aux autres, sans aucun degré de liberté, à l'aide de couches adhésives appelées « pré-imprégné » et plus connues sous le terme anglais de « prepreg ».

Un pré-imprégné est constitué d'une résine thermodurcissable imprégnant, généralement, un renfort tel qu'un tissu. Typiquement, la résine est une résine époxyde. Lors de la fabrication du circuit imprimé, la transformation de la résine thermodurcissable fait intervenir une polymérisation irréversible qui transforme le pré-imprégné en un matériau solide et rigide qui colle entre elles de façon irréversible les différentes couches du circuit imprimé. Typiquement, chaque transformation intervient lorsque le pré-imprégné est chauffé à une température élevée et est comprimé avec une pression élevée. Ici, une température élevée est une température supérieure à 100°C et, de préférence supérieure à 150°C. Une pression élevée est une pression supérieure à 0,3 MPa et, typiquement, supérieure à 1 MPa.

Les pistes conductrices des différentes couches de métallisation peuvent être électriquement raccordées par l'intermédiaire de plots conducteurs traversant les couches isolantes. Les plots conducteurs sont plus connus sous le terme de « vias ». Les vias s'étendent généralement perpendiculaires au plan des couches. Il existe différentes façons de fabriquer ces vias. L'une des plus communes consiste à réaliser un trou dans la ou les couches isolantes à traverser puis à recouvrir d'un métal la paroi intérieure de ces trous. On parle alors de trous métallisés.

Un via ne traverse pas nécessairement toutes les couches du circuit imprimé. Ainsi, il existe des vias borgnes qui débouchent sur une seule face extérieure du circuit imprimé. Aujourd'hui, il est également possible de réaliser des vias « enterrés », par exemple, à l'aide de technologies connues telles que la technologie connue sous l'acronyme de HDI (« High Density of Integration »). Un via enterré ne débouche sur aucune des faces extérieures du circuit imprimé. Par exemple, un via enterré permet de raccorder électriquement des pistes conductrices réalisées dans des couches de métallisation enfouies à l'intérieur du circuit imprimé.

Des circuits imprimés connus comportent :
- un empilement le long d'une direction verticale de plusieurs couches de métallisation séparées mécaniquement les unes des autres par des couches électriquement isolantes,
- au moins une première et une seconde bobines raccordées en série entre elles, ces première et seconde bobines étant enroulées, respectivement, autour d'un premier et d'un second axes d'enroulement, les spires de chacune de ces bobines étant formées par des pistes conductrices réalisées dans les couches de métallisation et raccordées électriquement les unes aux autres par des plots traversant au moins l'une des couches électriquement isolantes, la réunion de ces pistes conductrices et de ces plots traversant formant une seule et même ligne conductrice qui s'étend continument d'une extrémité de la première bobine vers une extrémité opposée de la seconde bobine.

Il est fréquent d'avoir à réaliser des bobines raccordées en série dans des capteurs de champ magnétique tels que les capteurs à vanne de flux plus connus sous le terme anglais de « fluxgate ». Dans ce cas, les bobines correspondent à des bobines d'excitation enroulées autour de barreaux magnétiques respectifs ou autour de branches respectives d'un anneau magnétique.

Dans les circuits imprimés connus, la réalisation des première et seconde bobines nécessite quatre vias entre chaque couche de métallisation empilée l'une au-dessus de l'autre. De plus, il faut également réaliser quatre plots de connexion pour alimenter ces deux bobines.

De l'état de la technique est également connu de :
- GB2 339 294 A,
- US 2006/001422 A1, et
- GB 2 265 013 A.

L'invention vise à simplifier la fabrication de ces bobines et du circuit imprimé dans lequel elles sont réalisées. Elle a donc pour objet un circuit imprimé conforme à la revendication 1.

Dans ce circuit imprimé, le nombre de vias nécessaires pour réaliser les première et seconde bobines est réduit. En effet, dans les première et seconde couches de métallisation, c'est la même piste qui est utilisée pour former les spires des première et seconde bobines. Cette piste conductrice n'a besoin que de deux vias pour être raccordée aux autres pistes conductrices réalisées dans les autres couches de métallisation. De plus, pour alimenter ces deux bobines, il suffit simplement de deux plots de connexion contre quatre dans le mode de réalisation connu.

Les modes de réalisation de ce circuit imprimé peuvent comporter une ou plusieurs des caractéristiques des revendications dépendantes.

Les modes de réalisation de ce circuit imprimé présentent en outre les avantages suivants :
- la réalisation de chaque bobine grâce à un bobinage descendant et un bobinage montant permet d'alimenter chaque bobine à partir de plots de connexion situés d'un même côté du circuit imprimé;
- l'existence de symétries axiales dans la superposition des pistes conductrices des première et seconde bobines permet de limiter l'importance du biais qui peut apparaître dans le champ magnétique généré ou mesuré par ces bobines par rapport à une bobine idéale,
- le fait que les pistes conductrices présentent également une symétrie centrale permet d'augmenter l'homogénéité du champ magnétique le long de l'axe d'enroulement.

L'invention a également pour objet un capteur de champ magnétique comportant :
- un noyau magnétique comportant deux branches parallèles,
- au moins deux bobines chacune enroulée autour d'une branche respective du noyau magnétique,
- le circuit imprimé ci-dessus dans lequel les deux bobines du circuit imprimé forment les deux bobines du capteur.

L'invention a également pour objet un générateur de tension alternative conforme à la revendication 9.

L'invention sera mieux comprise à la lecture de la description qui va suivre, donnée uniquement à titre d'exemple non limitatif et faite en se référant aux dessins sur lesquels :
- la figure 1 est une illustration schématique et en perspective d'un capteur de champ magnétique,
- les figures 2 à 5 sont des illustrations des pistes conductrices gravées dans différentes couches de métallisation pour réaliser des bobines du capteur de la figure 1,
- la figure 6 est une illustration de la superposition, dans un plan, des pistes conductrices illustrées dans les figures 3 et 4
- les figures 7 et 8 sont des illustrations schématiques et en perspective d'un anneau magnétique bobiné utilisé dans le capteur de la figure 1, dans des vues, respectivement, éclatée et assemblée,
- la figure 9 est une illustration schématique d'un détail de l'anneau magnétique bobiné des figures 7 et 8,
- la figure 10 est une illustration schématique et en perspective d'un générateur de tension alternative, et
- la figure 11 est une illustration en vue de dessus de pistes conductrices d'un circuit imprimé du générateur de la figure 10.

Dans ces figures, les mêmes références sont utilisées pour désigner les mêmes éléments.

Dans la suite de cette description, les caractéristiques et fonctions bien connues de l'homme du métier ne sont pas décrites en détail.

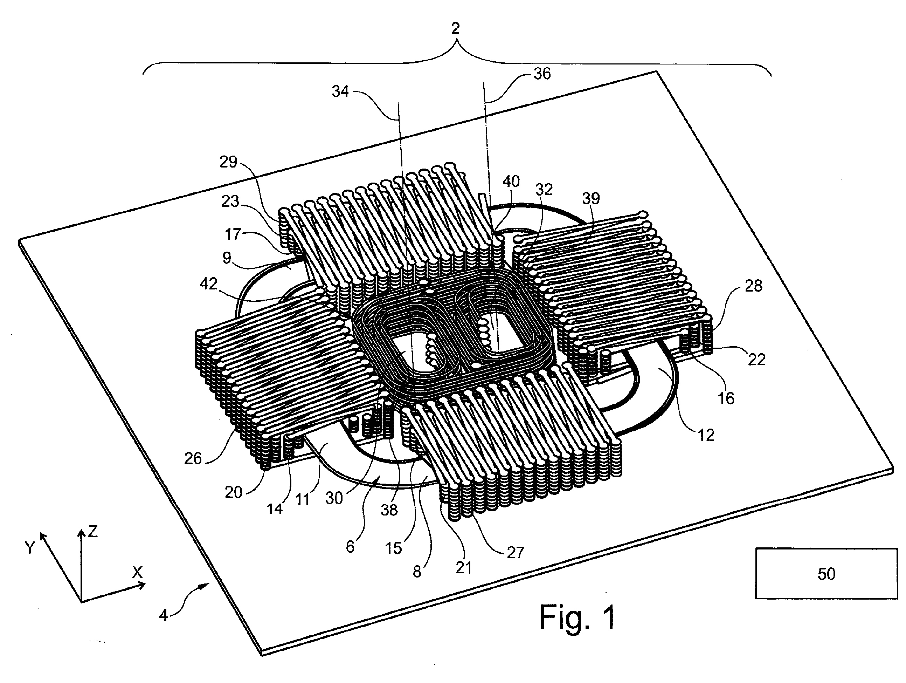

La figure 1 représente un capteur 2 à vanne de flux également appelé capteur fluxgate. Ce capteur 2 est capable de mesurer l'orientation et, éventuellement, l'intensité d'un champ magnétique extérieur T. Plus précisément, le capteur 2 mesure les composantes T_{X}, T_{Y} et T_{Z} correspondant, respectivement, aux projections du champ magnétique T sur trois directions non colinéaires X, Y et Z. Ici, les directions X, Y et Z sont orthogonales entre elles. La direction Z est la direction verticale et les directions X et Y définissent un plan horizontal.

Des capteurs à vanne de flux sont bien connus. On pourra par exemple se référer à la demande de brevet US 7 372 261 pour leur fonctionnement. Par conséquent, dans cette description, seuls les éléments nécessaires à la compréhension de l'invention sont décrits en détail.

Le capteur 2 comprend un circuit imprimé 4 multicouche. Typiquement, le circuit imprimé 4 comprend plus de deux ou cinq couches de métallisation et de préférence plus de dix couches de métallisation. Ici il comporte dix couches de métallisation. Pour simplifier la figure 1, seule une couche du circuit 4 a été illustrée. Les couches de métallisation sont empilées les unes au-dessus des autres dans la direction Z. La couche de métallisation la plus en haut dans la direction Z correspond à la face supérieure tandis que la couche de métallisation la plus en bas correspond à la face inférieure du circuit imprimé.

Le circuit imprimé 4 comprend un anneau magnétique 6 logé dans une cavité annulaire horizontale. L'anneau 6 est situé entre les faces supérieure et inférieure du circuit imprimé. Il est typiquement réalisé dans un matériau magnétique dont la perméabilité relative statique, c'est-à-dire à fréquence nulle, est supérieure à 1 000 et de préférence supérieure à 10 000. Par exemple, le matériau magnétique est un mumétal ou un matériau magnétique connu sous le nom commercial de Vitrovac® 6025.

Ici, l'anneau 6 est fabriqué indépendamment du circuit imprimé 4 puis inséré dans la cavité pendant la fabrication du circuit imprimé. A cet effet, les dimensions transversales de l'anneau 6, c'est-à-dire dans ce cas les dimensions de l'anneau dans un plan vertical, sont plus petites d'au moins 5 µm et, de préférence, d'au moins 100 µm par rapport aux dimensions transversales correspondantes de la cavité. Par conséquent, il existe un jeu entre les parois de la cavité et les faces en vis-à-vis de l'anneau 6. Grâce à ce jeu, l'anneau magnétique n'est pas mécaniquement contraint par le circuit imprimé 4. Ceci permet d'accroître notablement la précision du capteur 2 car toute contrainte mécanique exercée sur l'anneau 6 modifie ses propriétés magnétiques par magnétostriction et engendre donc des perturbations du champ magnétique T mesuré.

Ici, l'anneau 6 comprend deux barreaux 8 et 9 parallèles à la direction X et deux barreaux magnétiques 11 et 12 parallèles à la direction Y. Les extrémités de ces barreaux sont reliées les unes aux autres par un angle en matériau magnétique pour former l'anneau 6.

Pour saturer l'anneau magnétique 6, quatre bobines d'excitation 14 à 17 sont réalisées dans le circuit imprimé 4. Ces bobines d'excitation sont parcourues par un même courant d'excitation i_{exH} à une fréquence d'excitation f_{exH}. Typiquement, la fréquence d'excitation f_{exH} est supérieure à 300 Hz et, de préférence, supérieure à 10 kHz. Ici, les bobines 14 à 17 sont enroulées autour, respectivement, des barreaux 11, 8, 12 et 9.

Les bobines 14 à 17 sont raccordées en série les unes aux autres de manière à générer un champ magnétique d'excitation B_{exH} de même sens quand elles sont parcourues par le courant i_{exH}. Chaque bobine 14 à 17 est formée par des pistes conductrices réalisées dans deux couches de métallisation du circuit imprimé situées, respectivement, au-dessus et en dessous de l'anneau magnétique 6. Les extrémités de ces pistes conductrices sont raccordées entre elles par des vias verticaux pour former les spires des bobines 14 à 17. Un tel mode de réalisation de bobines s'étendant le long d'un axe horizontal est, par exemple, décrit dans la demande de brevet WO 2008/016198.

Le circuit imprimé 4 comporte également quatre bobines de mesure 20 à 23 enroulées, respectivement, autour des barreaux 11, 8, 12 et 9 pour mesurer le champ magnétique à l'intérieur de ces barreaux. Les mesures du champ magnétique réalisées par chacune de ces bobines 20 à 23 sont notées, respectivement, M₁, M₂, M₃ et M₄. Ici, ces mesures sont données par les relations suivantes :
- M₁ = T_{Y} - B_{exH},
- M₂ = T_{X} + B_{exH},
- M₃ T_{Y} + B_{exH}, et
- M₄ = T_{X} - B_{exH}.

Ces relations sont données avec les conventions suivantes :
- le champ magnétique d'excitation B_{exH} tourne dans le sens antihoraire, et
- les composantes T_{X} et T_{Y} sont dirigées dans la même direction que dans les directions X, Y respectivement.

Ici, les bobines 20 à 23 sont enroulées autour des bobines d'excitation, respectivement, 14 à 17. Ces bobines 20 à 23 sont formées par des pistes conductrices réalisées dans des couches de métallisation situées au-dessus et en dessous de celles utilisées pour réaliser les pistes conductrices des bobines d'excitation.

Dans ce mode de réalisation, quatre bobines de compensation 26 à 29 sont également enroulées, respectivement, autour des bobines de mesure 20 à 23 pour annuler le champ magnétique dans les barreaux, respectivement, 11, 8, 12 et 9. Dans ces conditions, la mesure des composantes T_{X} et T_{Y} se déduit de l'intensité du courant i_{cH} de compensation qui circule dans ces bobines 26 à 29.

Ces bobines 26 à 29 sont formées par des pistes conductrices réalisées dans des couches de métallisation situées au-dessus et en dessous de celles utilisées pour former les pistes conductrices des bobines de mesure.

Du fait que l'on travaille ici en champ magnétique nul, cela diminue le couplage magnétique entre les mesures réalisées selon les directions X et Y qui pourrait apparaître autrement.

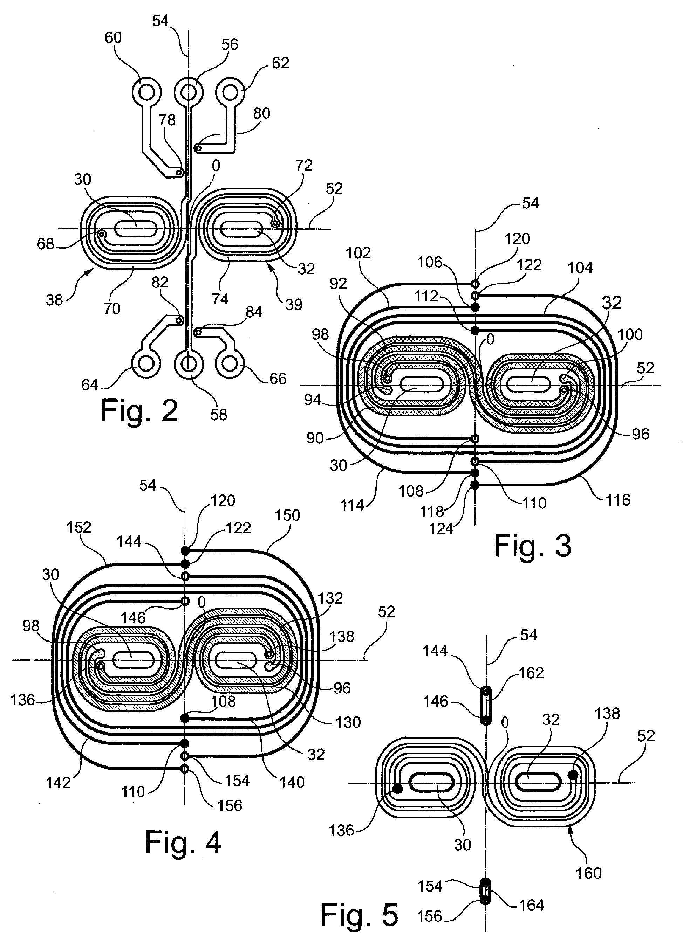

Le circuit imprimé 4 comprend aussi des bobines verticales pour mesurer la composante T_{Z}. Par bobine verticale, on désigne des bobines qui s'enroulent et s'étendent le long d'un axe vertical. Ces bobines sont décrites en détail en référence aux figures 2 à 5. Sur la figure 1, elles ne sont qu'illustrées très schématiquement.

Plus précisément, deux trous 30 et 32 traversent de part en part le circuit imprimé 4 le long, respectivement, d'axes verticaux 34 et 36. Ces trous 30 et 32 sont destinés à recevoir chacun une branche respective d'un anneau magnétique vertical. Cet anneau magnétique vertical n'a pas été représenté sur la figure 1 pour simplifier l'illustration. La figure 1 représente uniquement schématiquement l'emplacement de ces trous 30, 32 par rapport aux bobines qui les entourent. La conformation de ces trous est décrite plus en détail en référence aux figures 2 à 5.

Autour de ces trous 30 et 32, le circuit imprimé comprend deux bobines 38 et 39 d'excitation propres à générer un champ magnétique d'excitation Bₑₓᵥ capable de saturer l'anneau magnétique vertical lorsqu'elles sont parcourues par un courant d'excitation iₑₓᵥ de fréquence fₑₓᵥ. Par exemple, le courant iₑₓᵥ et la fréquence fₑₓᵥ sont pris égaux, respectivement, au courant i_{exH} et à la fréquence f_{exH}.

Une bobine verticale de mesure 40 entoure les deux trous 30 et 32. Cette bobine 40 est destinée à mesurer le champ magnétique dans l'anneau magnétique vertical.

Enfin, une bobine verticale de compensation 42 est également réalisée dans le circuit imprimé 4. Cette bobine entoure les trous 30 et 32. Comme précédemment, cette bobine a pour fonction d'annuler le champ magnétique dans l'anneau magnétique vertical lorsqu'elle est parcourue par un courant i_{cv} de compensation.

Les spires de ces bobines 38, 39, 40 et 42 sont formées par des pistes conductrices réalisées dans des couches de métallisation du circuit imprimé 4. Ces pistes conductrices sont raccordées les unes aux autres par l'intermédiaire de vias verticaux pour raccorder électriquement les spires d'une même bobine entre elles.

Enfin, le capteur 2 comporte une unité électronique 50 de traitement apte à commander l'alimentation des bobines d'excitation et de compensation et à traiter les signaux des bobines de mesure pour obtenir une mesure du champ magnétique T. Typiquement, la mesure de chaque composante du champ magnétique T est obtenue à partir de l'amplitude d'une harmonique de la fréquence d'excitation dans la tension recueillie aux bornes des bobines de mesure. Les connexions électriques entre l'unité 50 et les bobines n'ont pas été représentées pour simplifier la figure.

Ces bobines 38, 39, 40 et 42 vont maintenant être décrites plus en détail en référence aux figures 2 à 6.

Les figures 2 à 5 représentent les pistes conductrices réalisées, respectivement, dans une couche de métallisation supérieure, dans une couche de métallisation intermédiaire paire, dans une couche de métallisation intermédiaire impaire et dans une couche de métallisation inférieure. La couche de métallisation supérieure contient les pistes conductrices qui forment l'extrémité supérieure des bobines 38 à 40 et 42. La couche de métallisation inférieure contient les pistes conductrices qui forment les extrémités inférieures des bobines 38 à 40 et 42.

Les couches de métallisation intermédiaires sont situées entre les couches de métallisation supérieure et inférieure. Elles contiennent les pistes conductrices qui forment l'essentiel des spires de chaque bobine. Ici, les couches de métallisation intermédiaire sont empilées les unes au-dessus des autres en alternant une couche de métallisation paire et une couche de métallisation impaire. Les couches de métallisation paires sont toutes identiques entre elles de sorte qu'une seule de ces couches de métallisation paires sera décrite. De façon similaire, les couches de métallisation impaires sont toutes identiques entre elles et une seule de ces couches de métallisation impaires est décrite en détail en référence à la figure 4. Le nombre de couches de métallisation intermédiaires est supérieur à deux et, de préférence, supérieur à quatre ou huit.

Chacune de ces couches de métallisation est traversée par les trous 30 et 32. La section transversale de ces trous est identique dans chaque couche de métallisation. Ici, les trous 30 et 32 sont oblongs et s'étendent le long d'un même axe 52. L'axe 52 constitue également un axe de symétrie pour les trous 30, 32. Les trous 30 et 32 sont également symétriques par rapport à un autre axe 54 perpendiculaire à l'axe 52. Les axes 52 et 54 se coupent en un point O. Dans la suite de cette description, on désigne sous les mêmes références 52, 54 les mêmes axes de symétrie quelle que soit la couche de métallisation à laquelle ils appartiennent.

Dans ce mode de réalisation, chaque bobine 38, 39, 40 et 42 comprend un bobinage descendant et un bobinage montant. L'utilisation d'un bobinage descendant et d'un bobinage montant pour former une même bobine permet de réaliser les plots de connexion pour alimenter cette bobine sur une même face du circuit imprimé. Ici, ces plots de connexion sont réalisés sur la face supérieure.

Le bobinage descendant s'enroule autour du ou des trous 30, 32 en descendant de la face supérieure vers la face inférieure. A l'inverse, le bobinage montant s'enroule autour de ces mêmes trous en montant de la face inférieure vers la face supérieure. Les bobinages descendant et montant d'une même bobine sont raccordés en série pour que le courant qui les parcourt tourne toujours dans le même sens autour du ou des trous 30, 32.

Dans la suite de cette description, le terme « raccordé » désigne un raccordement électrique.

Les bobines 38 et 39 s'enroulent, en sens opposé, respectivement autour des trous 30 et 32. Les bobines 40 et 42 s'enroulent autour des bobines 38 et 39 et donc autour des trous 30 et 32. La bobine 42 s'enroule autour de la bobine 40.

Sur ces figures 2 à 5, un cercle situé à l'extrémité d'une piste conductrice représente un via descendant qui raccorde cette piste conductrice à une piste conductrice d'une couche de métallisation juste en dessous. A l'inverse, un point plein situé à l'extrémité d'une piste conductrice représente l'extrémité d'un via montant qui raccorde cette piste conductrice à une piste conductrice de la couche de métallisation juste au-dessus. Ainsi, le cercle correspond à l'extrémité supérieure d'un via tandis que le point correspond à l'extrémité inférieure de ce même via.

La figure 2 représente des plots 56 et 58 de connexion pour alimenter les bobines 38 et 39. Ces plots sont tous les deux situés sur l'axe 54 de part et d'autre de l'axe 52.

La couche de métallisation supérieure comporte également des plots 60 et 62 de connexion entre lesquels la bobine de mesure 40 génère une tension représentative du champ magnétique présent à l'intérieur de l'anneau magnétique vertical.

Cette couche de métallisation supérieure comprend aussi des plots 64 et 66 de connexion pour alimenter la bobine de compensation 42.

Le plot 56 est raccordé à un via descendant 68 par une piste conductrice 70. La piste conductrice 70 s'enroule dans le sens horaire en allant de l'extérieur vers l'intérieur autour du trou 30. Ici, cette piste 70 fait plusieurs tours complets avant d'atteindre le via 68.

Le plot 58 est raccordé à un via descendant 72 par une piste conductrice 74. La piste conductrice 74 est le symétrique de la piste conductrice 70 par une symétrie centrale par rapport au point O.

Les plots 60, 62, 64 et 66 sont raccordés, respectivement, à des vias descendants 78, 80, 82 et 84.

La figure 3 représente une couche de métallisation paire. Dans cette couche de métallisation, les spires des bobinages descendants des bobines 38 et 39 sont formées à l'aide d'une seule piste conductrice 90. De façon similaire, les spires des bobinages montants des bobines 38 et 39 sont formées à l'aide d'une seule piste conductrice 92. La piste conductrice 90 :
- s'enroule autour du trou 30 à partir d'un via montant 94 dans le sens horaire en allant de l'intérieur vers l'extérieur, puis
- s'enroule autour du trou 32 jusqu'à un via descendant 96 dans le sens antihoraire en allant de l'extérieur vers l'intérieur.

La piste conductrice 92 s'étend, à écartement constant, le long de la piste conductrice 90. Ainsi, la piste conductrice 92 :
- s'enroule à partir d'un via descendant 98 autour du trou 30 dans le sens horaire en allant de l'intérieur vers l'extérieur, puis
- s'enroule autour du trou 32 jusqu'à un via montant 100 dans le sens anti-horaire en allant de l'extérieur vers l'intérieur.

Ici, les pistes 92 et 94 font plusieurs tours chacune autour des trous 30 et 32.

Dans cette couche de métallisation, les spires des bobinages descendant et montant de la bobine 40 sont formées par seulement deux pistes conductrices, respectivement, 102 et 104. La piste 102 s'enroule à partir d'un via montant 106 autour des pistes conductrices 90 et 92 jusqu'à un via descendant 108 dans le sens anti-horaire en allant de l'extérieur vers l'intérieur. La piste 104 s'enroule à partir d'un via descendant 110 autour des pistes 90 et 92 jusqu'à un via montant 112 dans le sens anti-horaire en allant de l'extérieur vers l'intérieur. Les pistes 102 et 104 font plusieurs tours complets autour des trous 30 et 32.

Les spires des bobinages descendant et montant de la bobine 42 sont formées par seulement deux pistes conductrices, respectivement, 114 et 116. Les pistes 114 et 116 s'enroulent autour des pistes 102 et 104. Plus précisément, la piste 114 s'enroule à partir d'un via montant 118 vers un via descendant 120 en tournant dans le sens horaire. La piste 116 s'enroule autour des pistes 102 et 104 à partir d'un via montant 124 vers un via descendant 122 en tournant dans le sens anti-horaire. Dans cet exemple, les pistes 114 et 116 forment chacune uniquement un demi-tour dans cette couche de métallisation.

Les vias 106, 108, 110, 112, 118, 120 et 124 sont tous alignés sur l'axe 54.

Les pistes conductrices des bobinages montant et descendant de chaque bobine dans cette couche de métallisation présentent une symétrie centrale par rapport au point O mais aucune symétrie axiale.

La figure 4 représente les pistes conductrices réalisées dans la couche de métallisation impaire située juste en dessous de la couche de métallisation de la figure 3. Par conséquent, on retrouve dans cette figure les extrémités des vias descendants de la figure précédente. Ces extrémités portent donc les mêmes références.

Les spires des bobinages descendants et montants des bobines 38 et 39 sont formées par seulement deux pistes conductrices 130 et 132. La piste conductrice 130 s'étend du via 96 vers un via descendant 136. La piste 132 s'étend du via 98 vers un via descendant 138.

Les spires des bobinages descendant et montant de la bobine 40 sont formées par seulement deux pistes conductrices 140 et 142. La piste 140 s'étend du via 108 vers un via descendant 144. La piste 142 s'étend du via 110 vers un via descendant 146.

Enfin, les spires des bobinages descendant et montant de la bobine 42 sont formées par seulement deux pistes conductrices 150 et 152. La piste 150 s'étend du via 120 jusqu'à un via descendant 154 et la piste 152 s'étend du via 122 jusqu'à un via descendant 156.

Les pistes 130, 132, 140, 142, 150 et 152 se déduisent, respectivement, des pistes 92, 90, 104, 102, 116 et 114 par une symétrie axiale par rapport à l'axe 52. Les pistes 130, 132, 140, 142, 150 et 152 se déduisent également, respectivement, des pistes 90, 92, 102, 104, 114 et 116 par une symétrie axiale par rapport à l'axe 54. Ainsi, la structure de ces pistes n'est pas décrite ici plus en détail. On remarquera aussi que comme dans le cas de la figure 3, les pistes de chaque bobine présente une symétrie centrale par rapport au point O mais aucune symétrie axiale.

Les vias 108, 110, 120, 122, 144, 146, 154 et 156 sont alignés sur l'axe 54.

La figure 5 représente la couche de métallisation inférieure qui comporte des pistes conductrices pour raccorder les bobinages descendants et montants de chaque bobine entre eux. Ici, ces bobinages descendants et montants sont raccordés entre eux de manière à ce que le courant qui les traverse tourne dans le même sens quand ils sont alimentés. Pour simplifier la description, on suppose que cette couche de métallisation est juste en dessous de la couche de métallisation impaire de la figure 4. Par conséquent, on retrouve dans cette figure les extrémités inférieures des vias descendants précédemment décrits.

Les bobines 38 et 39 comprennent une piste conductrice 160 qui, en partant du via 136, s'enroulent autour du trou 30 en sens horaire en allant de l'intérieur vers l'extérieur, puis s'enroule autour du trou 32 jusqu'au via 138 dans le sens anti-horaire en allant de l'extérieur vers l'intérieur. Cette piste 160 présente une symétrie centrale par rapport au point O. La piste 160 fait plusieurs tours complets autours des trous 30,32.

Une piste conductrice 162 raccorde les vias 144 et 146 de la bobine de mesure 40. Une piste conductrice 164 raccorde les vias 154 et 156 de la bobine de compensation 42.

Les pistes 90, 92 ou 130, 132 d'une couche de métallisation intermédiaire ne peuvent pas présenter à elles seules une symétrie axiale car elles s'enroulent en sens opposé autour des trous 30 et 32.

L'ensemble des deux pistes conductrices 102, 104 ou l'ensemble des deux pistes conductrices 140, 142 ne peut pas présenter, non plus, de symétrie axiale dans une couche de métallisation intermédiaire. En effet, les pistes des bobinages descendant et montant sont réalisées dans la même couche de métallisation, ce qui impose de les décaler les unes par rapport aux autres. Cette remarque vaut également pour les pistes 90, 92 ; 130, 132 ; 114, 116 et 150, 152.

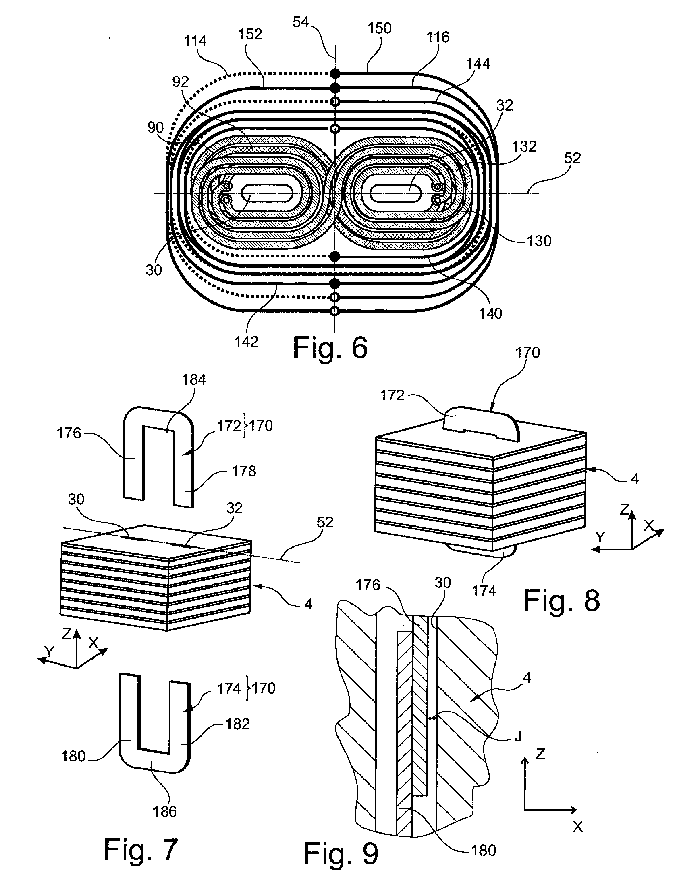

Or, l'un des objectifs des bobines conçues est d'augmenter leur symétrie de manière à améliorer l'homogénéité du champ magnétique le long de leurs axes d'enroulement respectifs et à limiter les biais observés par rapport à des bobines idéales. Pour cela, l'agencement décrit ici des pistes conductrices de chaque couche de métallisation paire et impaire fait apparaître de nouveaux axes de symétrie lorsque ces pistes conductrices sont superposées dans un plan horizontal. La superposition des couches de métallisation paire et impaire a été représentée dans la figure 6. Cette superposition fait apparaître deux symétries axiales, respectivement, par rapport aux axes 52 et 54. Cela permet de réduire le biais par rapport à des bobinages filaires et d'augmenter l'homogénéité du champ magnétique le long de l'axe d'enroulement. Quand les pistes de la couche de métallisation paire et impaire se superposent, seule l'une des pistes est visible sur la figure 6.

Enfin, dans le cas particulier décrit ici, la couche de métallisation paire située juste en dessous de la couche de métallisation supérieure ne présente pas de symétrie axiale parfaite quand on la superpose avec une couche de métallisation impaire. En effet, dans cette couche de métallisation paire, les vias 106, 112, 118 et 124 sont légèrement décalés par rapport à l'axe 54 pour correspondre aux extrémités des vias, respectivement, 80, 78, 84 et 82. Toutefois, à l'exception de cette couche de métallisation paire, toutes les autres couches de métallisation intermédiaires paire présentent deux symétries axiales parfaites quand on les superpose avec l'une quelconque des couches de métallisation impaire.

Les figures 7 et 8 représentent un anneau magnétique bobiné utilisé dans le capteur 2 pour réaliser la mesure de la composante T_{z}. Sur ces figures, les autres parties du capteur 2 n'ont pas été représentées. Plus précisément, cet anneau magnétique bobiné comprend un anneau magnétique 170 logé dans les trous 30 et 32 du circuit imprimé 4. La figure 7 est une vue éclatée de l'anneau magnétique bobiné tandis que la figure 8 est une vue assemblée de ce même anneau magnétique bobiné. L'anneau magnétique 170 est formé d'une partie supérieure 172 en « U » et d'une partie inférieure 174 en « U ». Les parties inférieure et supérieure présentent chacune deux branches verticales, respectivement, 176, 178 et 180, 182 reliées par un jambage horizontal, respectivement, 184 et 186 qui forme le fond des « U ».

Les parties 172 et 174 sont découpées dans une plaque en matériau magnétique dont la perméabilité relative statique est supérieure à 1 000 et de préférence supérieure à 10 000. Par exemple, le matériau magnétique est un mumétal ou un matériau magnétique connu sous le nom commercial de Vitrovac® 6025. Ainsi, leur fabrication limite les contraintes mécaniques appliquées au matériau magnétique. En particulier, cela permet d'éviter de plier le matériau magnétique pour former le « U ». Les parties 172, 174 s'étendent essentiellement dans un plan vertical YZ passant par l'axe 52. La largeur de chacune de ces parties 172, 174 est dans ce plan vertical. L'épaisseur des parties 172 et 174 est perpendiculaire à ce plan vertical. L'épaisseur est typiquement inférieure à 250 µm et, de préférence, inférieure à 100 µm ou 25 µm.

Les branches 176, 178 sont introduites dans les trous, respectivement, 30 et 32 à partir de la face supérieure du circuit imprimé 4. A l'inverse, les branches 180 et 182 sont introduites dans les trous, respectivement, 30 et 32 à partir de la face inférieure.

Comme illustré sur la figure 9, dans ce cas particulier, les branches 176 et 180 se superposent l'une au-dessus de l'autre, dans la direction X, à l'intérieur du trou 30 pour assurer la continuité magnétique. Par exemple, les branches 176 et 180 se superposent sur plus d'un tiers de leur longueur verticale. Les branches 178, 182 se superposent de façon similaire à l'intérieur du trou 32.

Les dimensions transversales des branches sont plus petites d'au moins 5 µm et, de préférence, d'au moins 100 µm par rapport aux dimensions transversales correspondantes des trous pour ménager un jeu entre les parois verticales du trou et les faces en vis-à-vis des branches. Plus précisément, les dimensions transversales des branches sont choisies pour qu'un jeu J supérieur à 5 µm apparaisse entre la partie la plus épaisse de l'anneau magnétique 170 et les parois verticales du trou. La partie la plus épaisse de l'anneau 170 est l'endroit où les branches se superposent l'une au-dessus de l'autre dans la direction X. Grâce à la présence de ce jeu, l'anneau magnétique 170 n'est pas contraint mécaniquement, ce qui permet d'augmenter la précision du capteur 2.

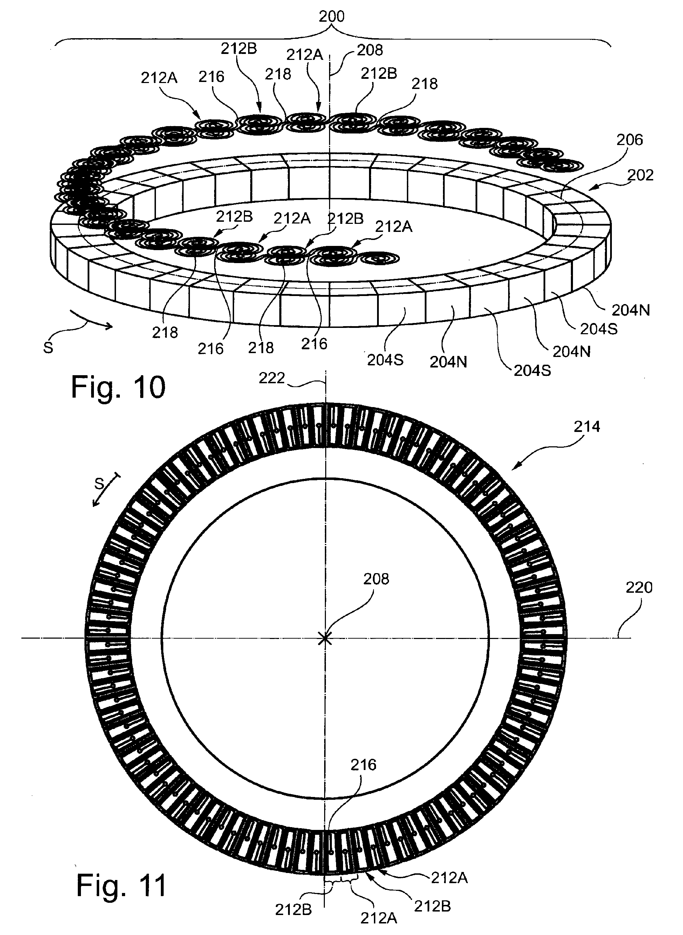

La figure 10 représente un générateur 200 d'une tension alternative à partir du déplacement d'un anneau aimanté 202. Ici, seuls les éléments nécessaires pour comprendre l'invention sont représentés. Ainsi, par exemple, les éléments qui déplacent l'anneau aimanté ou l'électronique de commande de ce générateur n'ont pas été représentés.

L'anneau 202 comprend une succession d'aimants 204 de polarité opposée disposés les uns à côté des autres le long d'une trajectoire 206. Ici, la trajectoire 206 est un cercle horizontal centré sur un axe de rotation vertical 208. Les aimants dont le pôle nord est tourné vers le haut portent la référence 204N. Les aimants dont le pôle sud est tourné vers le haut portent la référence 204S.

Les aimants 204 sont disposés le long de toute la trajectoire 206 en alternant les aimants 204N et 204S. Ici, un aimant 204S est introduit entre chaque aimant 204N. Par exemple, plus de dix aimants 204 sont disposés le long de la trajectoire 206.

Le générateur comprend également une succession de bobines 212 aptes à transformer le flux magnétique généré par chaque aimant 204 en une tension. Ces bobines 212 sont disposées pour cela en vis-à-vis de la succession d'aimants 204. Les bobines 212 sont disposées les unes à côté des autres le long de la trajectoire 206. Elles sont toutes identiques sauf qu'elles sont enroulées tantôt dans un sens et tantôt dans l'autre sens autour de leur axe vertical d'enroulement respectif. Les bobines 212 enroulées dans le sens horaire en partant de l'extérieur vers l'intérieur sont notées 212A. Les bobines 212 enroulées en sens inverse sont notées 212B. Les bobines 212A et 212B sont disposées en alternance le long de la trajectoire 206. Ici une bobine 212B est située entre chaque bobine 212A.

Les dimensions transversales des bobines 212 sont telles que quand une bobine 212A est en vis-à-vis d'un aimant 204N, les bobines 212B immédiatement adjacentes en amont et en aval se trouvent en vis-à-vis, respectivement, des aimants 204S immédiatement en amont et en aval de cet aimant 204N. De façon similaire, quand la bobine 212A est en vis-à-vis de l'aimant 204S, les bobines 212B immédiatement adjacentes en amont et en aval se trouvent en vis-à-vis, respectivement, des aimants 204N immédiatement en amont et en aval de cet aimant 204S. L'aval et l'amont sont ici définis par rapport à une direction S de rotation des aimants 204 par rapport aux bobines 212 autour de l'axe 208. Ainsi, quand une bobine 212 est en vis-à-vis d'un aimant 204, elle est essentiellement sensible au flux magnétique de cet aimant et non pas au flux magnétique des aimants adjacents.

Chaque bobine est formée par des pistes conductrices d'un circuit imprimé multicouche 214, ici deux couches (figure 11), raccordées entre elles par des vias verticaux. Sur la figure 10, le circuit imprimé 214 n'a pas été représenté pour simplifier cette illustration.

Ici, ces pistes conductrices sont réparties entre une couche de métallisation supérieure et une couche de métallisation inférieure.

Pour diminuer le nombre de vias verticaux utilisés, les bobines 212 sont regroupées en paires. Chaque paire comprend une bobine 212A et une bobine 212B immédiatement adjacente dans la direction S. Dans chaque paire, la bobine 212B est en amont de la bobine 212A.

Dans la couche de métallisation supérieure, les spires des bobines 212A et 212B d'une même paire sont formées à l'aide d'une seule piste conductrice 216. La piste 216 :
- s'enroule autour de l'axe d'enroulement de la bobine 212B, à partir d'un via descendant, dans le sens antihoraire en allant de l'intérieur vers l'extérieur, puis
- s'enroule autour de l'axe d'enroulement de la bobine 212A en allant dans le sens horaire de l'extérieur vers l'intérieur jusqu'à un autre via montant.

Ici, la piste 216 fait plusieurs tours complets autour de chaque axe d'enroulement. Par exemple la piste 216 est identique à la piste 90 précédemment décrite.

Les spires de la bobine 212B dans la couche de métallisation inférieure sont formées par une piste conductrice 218. La piste 218 s'enroule autour de l'axe d'enroulement de la bobine 212B dans le sens horaire en allant de l'extérieur vers l'intérieur jusqu'à l'extrémité inférieure du via montant. La piste 218 s'enroule également autour de l'axe d'enroulement de la bobine 212A de la paire immédiatement en amont dans le sens horaire en allant de l'extérieur vers l'intérieur.

Les spires dans la couche de métallisation inférieure de la bobine 212A de cette paire sont formées par la piste conductrice 218 qui forme également les spires de la bobine 212B de la paire immédiatement en aval.

Ainsi, la piste 218 forme à la fois les spires des bobines 212A et 212B de deux paires adjacentes. Elle raccorde également en série les bobines de ces paires adjacentes de manière à ce que le courant qui circule dans les spires d'une bobine 212 tourne toujours dans le même sens aussi bien dans la couche de métallisation supérieure qu'inférieure. Ce raccordement en série permet d'additionner les tensions générées par chacune des bobines lorsque celles-ci se trouvent en vis-à-vis d'un aimant 204. La piste 218 est similaire à la piste 130 précédemment décrite mais décalée d'un pas angulaire. Ce pas angulaire est égal à l'angle entre deux axes verticaux d'enroulement successifs des bobines 212 et le centre 208.

La figure 11 représente la couche de métallisation supérieure du circuit imprimé 214. Sur cette figure, les extrémités supérieures des vias sont représentées par des ronds. Ces extrémités supérieures sont toutes alignées sur un même cercle centré sur l'axe 208. Les pistes conductrices 216 de la couche de métallisation supérieure présente deux symétries axiales par rapport à des axes 220 et 222. Les axes 220 et 222 sont orthogonaux entre eux et contenus dans le plan de la couche de métallisation supérieure.

De plus, dans ce mode de réalisation, la superposition des pistes conductrices 216 et 218 dans un plan horizontal crée un motif qui présente une symétrie de révolution. Plus précisément, ce motif est invariant par une rotation d'un pas angulaire égal à la distance angulaire entre deux axes verticaux d'enroulement successifs des bobines 212.

Lors de son fonctionnement, lorsqu'une bobine 212A d'une paire de bobines se trouve en face d'un aimant 204N, elle génère une tension U. Dans le même temps, la bobine 212B de la même paire se trouve en face d'un aimant 204S et génère donc également une tension U. Le même phénomène se reproduit dans chaque paire de bobines 212. Etant donné que ces paires de bobines sont raccordées en série, les tensions 2U générées par chaque paire s'additionnent donc de manière à obtenir une tension beaucoup plus importante. Lorsque l'anneau aimanté 202 se déplace par rapport au circuit imprimé 214, la bobine 212A qui était précédemment en vis-à-vis de l'aimant 204N se trouve maintenant en vis-à-vis de l'aimant 204S suivant. Dans ces conditions, cette bobine 212A comme toutes les autres bobines génère une tension -U. Ainsi, en déplaçant en rotation le circuit imprimé 214 par rapport à l'anneau aimanté 202, une tension alternative est générée.

De nombreux autres modes de réalisation sont possibles. Par exemple, pour augmenter l'épaisseur du circuit imprimé, plusieurs circuits imprimés réalisés comme décrits précédemment peuvent être empilés les uns au-dessus des autres dans la direction verticale. Lors de cet empilement, ces circuits imprimés sont raccordés entre eux en préservant le sens d'enroulement des spires de chaque bobine. Superposer plusieurs circuits imprimés multicouches permet ainsi d'augmenter le rapport longueur/largeur des anneaux magnétiques, ainsi que le nombre de spires du capteur.

Les pistes conductrices peuvent être gravées dans la couche de métallisation ou déposées dans cette couche de métallisation.

Dans une variante simplifiée, une seule bobine d'excitation est utilisée pour générer le champ magnétique d'excitation dans l'ensemble de l'anneau magnétique.

Les pistes conductrices qui forment les différentes bobines peuvent ne faire qu'une demi-spire autour des trous 30 et 32 comme illustré dans le cas de la bobine 42 de compensation. Une demi-spire est un simple demi-tour autour de l'axe d'enroulement. Dans une autre variante, les bobinages montants sont omis.

Le circuit imprimé peut également comporter des couches de métallisation intermédiaires comportant des pistes conductrices qui, lorsqu'elles sont superposées dans un plan horizontal, ne font pas apparaître un motif présentant deux symétries axiales.

Les couches décrites en référence aux figures 2 et 5 peuvent être omises. Dans ce cas, les connexions électriques avec les bobines se font directement sur les couches intermédiaires.

Dans chaque couche intermédiaire, les pistes 96 et 98 peuvent être fusionnées. On obtient alors un bobinage uniquement descendant mais présentant une bonne symétrie.

En variante, c'est la superposition des pistes conductrices de plus de trois couches de métallisation qui fait apparaître un motif présentant deux symétries axiales.

Il n'est pas nécessaire que les couches de métallisation qui se superposent pour former un motif ayant des symétries axiales soient des couches de métallisation immédiatement successives dans l'empilement de couches de métallisation.

L'anneau magnétique vertical peut être remplacé par deux barreaux magnétiques parallèles. Contrairement à l'anneau magnétique, ces barreaux sont magnétiquement isolés l'un de l'autre par un entrefer important. Dans ce cas, les spires des bobines d'excitation sont enroulées dans le même sens, respectivement, autour des axes 34 et 36 de ces barreaux. Dans cette configuration aussi, les pistes conductrices des couches de métallisation paire et impaire sont agencées pour que leur superposition dans un plan horizontal fasse apparaître un motif avec deux symétries axiales.

L'enroulement spécifique des bobines d'excitation décrit ici peut aussi être mis en oeuvre pour réaliser des bobines d'excitations enroulées et s'étendant le long d'axes d'enroulement horizontaux et parallèles. Comme précédemment décrit, cela permet de limiter le nombre de vias verticaux situés entre les branches d'un anneau magnétique horizontale ou entre des barreaux magnétiques horizontaux parallèles et magnétiquement isolés l'un de l'autre.

La partie en « U » du noyau magnétique bobiné peut être obtenue en pliant un ruban ou un fil. Dans ce cas, de préférence, le ruban ou le fil est enroulé pour former une ou plusieurs spires traversant chacune les trous 30 et 32.

Plusieurs parties en « U » peuvent être insérées à l'intérieur des trous à partir de la même face du circuit imprimé de manière à augmenter l'épaisseur de l'anneau magnétique dans une direction horizontale.

Les branches verticales 176, 178 peuvent être logées à l'intérieur d'un guide rigide. Par exemple, le guide est réalisé dans un matériau ou une combinaison de matériaux présentant un module de Young à 25°C supérieur à 5 GPa et, de préférence, supérieur à 50 GPa. Le guide rigide permet de faciliter l'insertion des branches verticales dans les trous 30, 32. Dans ce cas, le jeu entre les branches verticales et ce guide correspond au jeu décrit ci-dessus entre les branches verticales et les parois des trous 30, 32. Le guide permet également de mieux positionner les éléments magnétiques. Le guide a typiquement une section transversale horizontale en forme de « U » pour recevoir chaque branche verticale.

En variante, un isolant diélectrique est inséré entre les branches des parties en « U » qui se superposent de manière à les isoler électriquement les unes des autres. Pour cela, il est possible de découper dans un matériau électriquement isolant une partie en « U » puis d'introduire cet isolant en « U » entre les parties en « U » inférieure et supérieure 172 et 174. Une autre possibilité consiste à vernir ou à introduire un liquide visqueux ou collant sur les faces extérieures des parties 172 et 174 qui se chevauchent. Une autre solution consiste encore à traiter la surface des branches pour la rendre électriquement isolante. Ce traitement est connu sous le terme de « passivation ».

La trajectoire le long de laquelle sont disposés les aimants et les spires 212 n'est pas nécessairement circulaire. Par exemple, en variante, elle est rectiligne.

Les spires de la couche de métallisation inférieure du circuit imprimé du générateur de tension ne sont pas nécessairement identiques aux spires réalisées dans la couche de métallisation supérieure. Par exemple, le nombre de spires dans la couche de métallisation inférieure peut être plus petit ou plus grand que le nombre de spires dans la couche de métallisation supérieure.

Le circuit imprimé 114 peut comporter une ou plusieurs couches de métallisation dans lesquelles sont formées des spires supplémentaires.

## Revendications

1. Circuit imprimé comportant :
- un empilement le long d'une direction verticale de plusieurs couches de métallisation séparées mécaniquement les unes des autres par des couches électriquement isolantes,
- au moins une première et une seconde bobines (38, 39) raccordées en série entre elles, ces première et seconde bobines étant enroulées, respectivement, autour d'un premier et d'un second axes (34, 36) d'enroulement verticaux, les spires de chacune de ces bobines étant formées par des pistes conductrices réalisées dans les couches de métallisation et raccordées électriquement les unes aux autres par des plots traversant au moins l'une des couches électriquement isolantes, la réunion de ces pistes conductrices et de ces plots traversant formant une seule et même ligne conductrice qui s'étend continûment d'une extrémité de la première bobine vers une extrémité opposée de la seconde bobine,
**caractérisé en ce que** les première et seconde bobines (38, 39) comportent :
- une même première piste conductrice (90), réalisée dans une première couche de métallisation, enroulée autour du premier axe vertical (34) d'enroulement et enroulée autour du second axe vertical (36) d'enroulement, et
- une même deuxième piste conductrice (130), réalisée dans une seconde couche de métallisation, enroulée autour du premier axe vertical (34) d'enroulement et enroulée autour du second axe vertical (36) d'enroulement,
- un premier plot (96) traversant au moins l'une des couches isolantes pour raccorder électriquement les première et deuxième pistes conductrices l'une à l'autre de manière à ce que, lorsqu'elles sont alimentées, le courant tourne toujours dans le même sens autour du premier axe d'enroulement et toujours dans le même sens ou dans un sens opposé atour du second axe d'enroulement.

2. Circuit selon la revendication 1, dans lequel les première et seconde bobines (38, 39) comporte chacune :
- un bobinage descendant qui s'enroule en descendant autour de chacun des axes verticaux (34, 36) d'enroulement, des spires de ce bobinage descendant étant formées par les première et deuxième pistes conductrices (90, 130), et
- un bobinage montant qui s'enroule en montant autour de chacun des axes verticaux (34, 36) d'enroulement, des spires de ce bobinage montant étant formées par :
• une troisième piste conductrice (92), réalisée dans la première couche de métallisation, enroulée autour du premier axe (34) d'enroulement et autour du second axe (36) d'enroulement,
• une quatrième piste conductrice (132), réalisée dans la seconde couche de métallisation, enroulée autour du premier axe (34) d'enroulement et autour du second axe (36) d'enroulement,
• un second plot (98) traversant au moins l'une des couches isolantes pour raccorder électriquement les troisième et quatrième pistes conductrices l'une à l'autre,
ces bobinages descendant et montant étant raccordés en série de manière à ce que le courant tourne dans le même sens aussi bien dans le bobinage montant que dans le bobinage descendant.

3. Circuit selon la revendication 1 ou 2, dans lequel les pistes conductrices des première et seconde bobines (38, 39) sont agencées, dans les première et seconde couches de métallisation immédiatement consécutives dans la direction verticale, de manière à ce que leur superposition dans un plan parallèle aux couches forme un motif présentant au moins deux symétries axiales par rapport à des axes X et Y, ces axes X et Y étant orthogonaux entre eux et parallèles aux couches de métallisation, la ou les pistes conductrices de chacune des couches de métallisation superposées étant dépourvues, à elles seules, de symétrie axiale par rapport à l'axe X ou Y.

4. Circuit selon la revendication 3, dans lequel :
- l'empilement comprend une couche de métallisation supérieure, une couche de métallisation inférieure et entre ces couches de métallisation supérieure et inférieure N couches de métallisation intermédiaires, où N est un entier naturel strictement supérieur ou égal à deux, et
- il existe plus de N-2 paires de deux couches de métallisation intermédiaires immédiatement empilées l'une sur l'autre, pour lesquelles la superposition des pistes conductrices des première et seconde bobines (38, 39) réalisées dans les couches de métallisation de cette paire forme un motif présentant au moins deux symétries axiales par rapport aux axes X et Y.

5. Circuit selon les revendications 2 et 3, dans lequel, dans la superposition, les première et troisième pistes (90, 92) conductrices sont les symétriques des deuxième et quatrième pistes conductrices (130, 132) par rapport à l'axe Y et à l'axe X.

6. Circuit selon l'une quelconque des revendications 1 à 5, dans lequel les pistes conductrices (90, 92) de la première couche de métallisation présentent une symétrie centrale autour d'un premier centre et les pistes conductrices (130, 132) de la seconde couche de métallisation présentent une symétrie centrale autour d'un second centre, les premier et second centres étant superposés l'un au-dessus de l'autre dans la direction verticale.

7. Circuit selon l'une quelconque des revendications précédentes, dans lequel chaque piste conductrice (90, 92, 130, 132) s'enroule dans un sens autour du premier axe et dans un sens opposé autour du second axe.

8. Capteur de champ magnétique, ce capteur comportant :
- un noyau magnétique (170) comportant deux branches parallèles (176, 178, 180, 182),
- au moins deux bobines (38, 39) chacune enroulée autour d'une branche respective du noyau magnétique,
**caractérisé en ce que** le capteur comporte un circuit imprimé (4) conforme à l'une quelconque des revendications précédentes, les deux bobines du circuit imprimé formant les deux bobines du capteur.

9. Générateur d'une tension alternative, ce générateur comportant :
- une succession d'aimants (204) de polarité opposée, ces aimants étant disposés les uns à côtés des autres, en alternant les polarités, le long d'une trajectoire de déplacement
- une succession de bobines (212) en vis-à-vis de la succession d'aimants, ces bobines étant disposées les unes à côté des autres le long de la trajectoire de déplacement en alternant leur sens d'enroulement, chaque bobine étant dimensionnée pour être essentiellement sensible au champ magnétique d'un seul aimant lorsque celui-ci est en vis-à-vis de cette bobine, cette succession de bobines étant déplaçable par rapport à la succession d'aimants le long de la trajectoire pour générer la tension alternative, et
- un circuit imprimé (214) comprenant au moins une couche de métallisation,
**caractérisé en ce que** :
- les bobines (212) sont regroupées en paires de bobines immédiatement adjacentes le long de la direction de déplacement, les première et seconde bobines (212B, 212A) d'une même paire étant formées par une même piste conductrice (216) enroulée dans un sens autour d'un premier axe d'enroulement de la première bobine (212B) et enroulée dans le sens opposé autour d'un second axe d'enroulement de la seconde bobine (212A), cette piste étant réalisée dans une première couche de métallisation du circuit imprimé,
- la première bobine (212B) est également formée d'une seconde piste conductrice (218) réalisée dans une autre couche de métallisation du même circuit imprimé, cette seconde piste conductrice étant enroulée dans le même sens que la première piste conductrice (216) autour du même premier axe d'enroulement et enroulée en sens opposé autour de l'axe d'enroulement de la seconde bobine (212A) de la paire de bobines immédiatement adjacente en amont, et
- la seconde bobine (212A) est également formée d'une troisième piste conductrice (218) réalisée dans une autre couche de métallisation du même circuit, cette troisième piste conductrice étant enroulée dans le même sens que la première piste conductrice autour du même second axe d'enroulement et enroulée en sens opposé autour de l'axe d'enroulement de la première bobine (212B) de la paire de bobines immédiatement adjacente en aval, l'amont et l'aval étant définis par rapport à la direction de déplacement.

## Patentansprüche

1. Gedruckte Schaltung, umfassend:
- eine Stapelung mehrerer mechanisch voneinander durch elektrisch isolierende Schichten getrennter Metallisierungsschichten,
- mindestens eine erste und eine zweite Spule (38, 39), die in Serie aneinander angeschlossen sind, wobei diese erste und zweite Spule um eine erste bzw. zweite vertikale Wickelachse (34, 36) gewickelt sind, wobei die Windungen jeder dieser Spulen von leitenden Spuren gebildet sind, die in den Metallisierungsschichten ausgeführt und elektrisch aneinander durch Stifte, die durch mindestens eine der elektrisch isolierenden Schichten hindurchgehen, angeschlossen sind, wobei die Vereinigung dieser leitenden Spuren und dieser durchgehenden Stifte eine einzige und selbe leitende Linie bildet, die sich kontinuierlich von einem Ende der ersten Spule zu einem gegenüberliegenden Ende der zweiten Spule erstreckt,
**dadurch gekennzeichnet, dass** die erste und zweite Spule (38, 39) umfassen:
- eine selbe erste leitende Spur (90), die in einer ersten Metallisierungsschicht ausgeführt ist, die um die erste vertikale Wickelachse (34) gewickelt und um die zweite vertikale Wickelachse (36) gewickelt ist, und
- eine selbe zweite leitende Spur (130), die in einer zweiten Metallisierungsschicht angeordnet ist, die um die erste vertikale Wickelachse (34) und um die zweite vertikale Wickelachse (36) gewickelt ist,
- einen ersten Stift (96), der mindestens durch eine der isolierenden Schichten hindurchgeht, um die erste und die zweite leitende Spur elektrisch aneinander anzuschließen, so dass sich der Strom wenn sie angespeist werden, immer in dieselbe Richtung um die erste Wickelachse und immer in dieselbe Richtung oder in eine entgegengesetzte Richtung um die zweite Wickelachse dreht.

2. Schaltung nach Anspruch 1, bei der die erste und die zweite Spule (38, 39) jeweils umfassen:
- eine absteigende Wicklung, die sich beim Absteigen um jede der vertikalen Wickelachsen (34, 36) wickelt, wobei die Windungen dieser absteigenden Wicklung von der ersten und der zweiten leitenden Spur (90, 130) gebildet sind, und
- eine aufsteigende Wicklung, die sich beim Aufsteigen um jede der vertikalen Wickelachsen (34, 36) wickelt, wobei die Windungen dieser aufsteigenden Wicklung gebildet sind von:
• einer dritten leitenden Spur (92), die in der ersten Metallisierungsschicht ausgeführt ist, die um die erste Wickelachse (34) und um die zweite Wickelachse (36) gewickelt ist,
• einer vierten leitenden Spur (132), die in der zweiten Metallisierungsschicht ausgeführt ist, die um die erste Wickelachse (34) und um die zweite Wickelachse (36) gewickelt ist,
• einem zweiten Stift (98), der zumindest durch eine der isolierenden Schichten hindurchgeht, um die dritte und die vierte leitende Spur elektrisch aneinander anzuschließen,
wobei diese absteigenden und aufsteigenden Wicklungen in Serie angeschlossen sind, so dass sich der Strom sowohl in der aufsteigenden Wicklung als auch in der absteigenden Wicklung in dieselbe Richtung dreht.

3. Schaltung nach Anspruch 1 oder 2, bei der die leitenden Spuren der ersten und zweiten Spulen (38, 39) in der ersten und zweiten Metallisierungsschicht, die in Vertikalrichtung direkt aufeinanderfolgen, angeordnet sind, so dass ihre Übereinanderlagerung in einer Ebene parallel zu den Schichten ein Motiv bildet, das mindestens zwei Axialsymmetrien in Bezug zu X- und Y-Achsen aufweist, wobei diese X- und Y-Achsen zueinander orthogonal und zu den Metallisierungsschichten parallel sind, wobei die leitende(n) Spur(en) jeder der übereinander gelagerten Metallisierungsschichten für sich alleine keine Axialsymmetrie in Bezug zur X- oder Y-Achse aufweisen.

4. Schaltung nach Anspruch 3, bei der:
- die Stapelung eine obere Metallisierungsschicht, eine untere Metallisierungsschicht und zwischen dieser oberen und unteren Metallisierungsschicht N Zwischenmetallisierungsschichten umfasst, wobei N eine natürliche ganze Zahl unbedingt größer oder gleich zwei ist, und
- mehr als N-2 Paare von zwei unmittelbar übereinander gestapelten Zwischenmetallisierungsschichten vorhanden sind, bei denen die Übereinanderlagerung der leitenden Spuren der ersten und zweiten Spulen (38, 39), die in den Metallisierungsschichten dieses Paars ausgeführt sind, ein Motiv bildet, das mindestens zwei Axialsymmetrien in Bezug zu X- und Y-Achsen aufweist.

5. Schaltung nach den Ansprüchen 2 und 3, bei der in der Übereinanderlagerung die erste und dritte leitende Spur (90, 92) die Entsprechungen der zweiten und vierten leitenden Spuren (130, 132) in Bezug zur Y-Achse und Y-Achse sind.

6. Schaltung nach einem der Ansprüche 1 bis 5, bei der die leitenden Spuren (90, 92) der ersten Metallisierungsschicht eine zentrale Symmetrie um einen ersten Mittelpunkt aufweisen, und die leitenden Spuren (130, 132) der zweiten Metallisierungsschicht eine zentrale Symmetrie um einen zweiten Mittelpunkt aufweisen, wobei der erste und der zweite Mittelpunkt in Vertikalrichtung übereinander angeordnet sind.

7. Schaltung nach einem der vorhergehenden Ansprüche, bei der sich jede leitende Spur (90, 92, 130, 132) in eine Richtung um die erste Achse und in eine entgegengesetzte Richtung um die zweite Achse wickelt.

8. Magnetfeldsensor, wobei dieser Sensor umfasst:
- einen Magnetkern (170), umfassend zwei parallele Abschnitte (176, 178, 180, 182),
- mindestens zwei Spulen (38, 39), die jeweils um einen jeweiligen Abschnitt des Magnetkerns gewickelt sind,
**dadurch gekennzeichnet, dass** der Sensor eine gedruckte Schaltung (4) nach einem der vorhergehenden Ansprüche umfasst, wobei die beiden Spulen der gedruckten Schaltung die beiden Spulen des Sensors bilden.

9. Wechselspannungsgenerator, wobei dieser Generator umfasst:
- eine Aufeinanderfolge von Magneten (204) mit entgegengesetzter Polarität, wobei diese Magneten nebeneinander mit alternierenden Polaritäten entlang einer Bewegungsbahn angeordnet sind,
- eine Aufeinanderfolge von Spulen (212) gegenüber der Aufeinanderfolge von Magneten, wobei diese Spulen nebeneinander entlang der Bewegungsbahn mit alternierender Wickelrichtung angeordnet sind, wobei jede Spule derart dimensioniert ist, dass sie im Wesentlichen für das Magnetfeld eines einzigen Magneten empfindlich ist, wenn sich dieser gegenüber dieser Spule befindet, wobei diese Aufeinanderfolge von Spulen in Bezug zu der Aufeinanderfolge von Magneten entlang der Bahn verschiebbar ist, um die Wechselspannung zu erzeugen, und
- eine gedruckte Schaltung (214), umfassend mindestens eine Metallisierungsschicht.
**dadurch gekennzeichnet, dass**
- die Spulen (212) zu unmittelbar aneinandergrenzenden Spulenpaaren entlang der Bewegungsrichtung zusammengefasst sind, wobei die erste und zweite Spule (212B, 212A) eines selben Paars von einer selben leitenden Spur (216) gebildet sind, die in eine Richtung um eine erste Wickelachse der ersten Spule (212B) und in die entgegengesetzte Richtung um eine zweite Wickelachse der zweiten Spule (212A) gewickelt ist, wobei diese Spur in einer ersten Metallisierungsschicht der gedruckten Schaltung ausgeführt ist,
- die erste Spule (212B) auch von einer zweiten leitenden Spur (218) gebildet ist, die in einer weiteren Metallisierungsschicht derselben gedruckten Schaltung ausgeführt ist, wobei diese zweite leitende Schicht in dieselbe Richtung wie die erste leitende Spur (216) um die erste Wickelachse und in die entgegengesetzte Richtung um die Wickelachse der zweiten Spule (212A) des unmittelbar stromaufwärts angrenzenden Spulenpaars gewickelt ist, und
- die zweite Spule (212A) auch von einer dritten leitenden Spur (218) gebildet ist, die in einer weiteren Metallisierungsschicht derselben Schaltung ausgeführt ist, wobei diese dritte leitende Spur in dieselbe Richtung wie die erste leitende Spur um dieselbe zweite Wickelachse und in entgegengesetzte Richtung um die Wickelachse der ersten Spule (212B) des unmittelbar stromabwärts angrenzenden Spulenpaars gewickelt ist, wobei stromaufwärts und stromabwärts in Bezug zur Bewegungsrichtung definiert sind.

## Claims

1. A printed circuit comprising:
- a stack, along a vertical direction, of several metallization layers mechanically separated from one another by electrically insulating layers,
- at least one first and one second coil (38, 39) serially connected to each other, these first and second coils being wound respectively around first and second vertical winding axes (34, 36), the turns of each of these coils being formed by conductive tracks made in the metallization layers and electrically connected to one another by pads traversing at least one of the electrically insulating layers, the joining of these conductive tracks and these through pads forming one and the same conductive line that extends continuously from one end of the first coil to an opposite end of the second coil,
**characterized in that** the first and second coils (38, 39) comprise:
- a same first conductive track (90), made in a first metallization layer, wound around the first vertical winding axis (34) and wound around the second vertical winding axis (36), and
- a same second conductive track (130), made in a second metallization layer, wound around the first vertical winding axis (34) and wound around the second vertical winding axis (36),
- a first pad (96) traversing at least one of the insulating layers to electrically connect the first and second conductive tracks to each other so that, when they are powered, current always turns in the same direction around the first winding axis and always in the same direction or in an opposite direction around the second winding axis.

2. The circuit according to claim 1, in which the first and second coils (38, 39) each comprise:
- a downward coiling that is wound downward around each of the vertical winding axes (34, 36), the turns of this downward coiling being formed by the first and second conductive tracks (90, 130), and
- an upward coiling that is wound upward around each of the vertical winding axes (34, 36), the turns of this upward coiling being formed by:
□ a third conductive track (92), made in the first metallization layer, wound around the first winding axis (34) and around the second winding axis (36),
□ a fourth conductive track (132), made in the second metallization layer, wound around the first winding axis (34) and around the second winding axis (36),
□ a second pad (98) traversing at least one of the insulating layers to electrically connect the third and fourth conductive tracks to each other,
these downward and upward coilings being serially connected so that current turns in the same direction both in the upward coiling and in the downward coiling.

3. The circuit according to claim 1 or 2, in which the conductive tracks of the first and second coils (38, 39) are arranged, in the first and second metallization layers, immediately consecutively along the vertical direction, so that their superimposition in a plane parallel to the layers forms a pattern presenting at least two axial symmetries relative to X and Y axes, these X and Y axes being orthogonal to each other and parallel to the metallization layers, the conductive track or tracks of each of the superimposed metallization layers being devoid, in themselves, of axial symmetry relative to the X or Y axes.

4. The circuit according to claim 3, in which:
- the stack comprises an upper metallization layer, a lower metallization layer and, between these upper and lower metallization layers, N intermediate metallization layers, where N is a natural integer strictly greater than or equal to two, and
- more than N-2 pairs of two intermediate metallization layers immediately stacked on one another, for which the superimposition of conductive tracks of first and second coils (38, 39) made in the metallization layers of this pair forms a pattern presenting at least two axial symmetries relative to the X and Y axes, exist.

5. The circuit according to claims 2 and 3, in which, in the superimposition, the first and third conductive tracks (90, 92) are symmetrical with the second and fourth conductive tracks (130, 132) relative to the X and Y axes.

6. The circuit according to any one of claims 1 to 5, in which the conductive tracks (90, 92) of the first metallization layer present a central symmetry around a first centre and the conductive tracks (130, 132) of the second metallization layer present a central symmetry around a second centre, the first and second centres being superimposed on one another along the vertical direction.

7. The circuit according to any one of the previous claims, in which each conductive track (90, 92, 130, 132) is wound in one direction around the first axis and in an opposite direction around the second axis.

8. A magnetic field sensor, this sensor comprising:
- a magnetic core (170) comprising two parallel arms (176, 178, 180, 182),
- at least two coils (38, 39) each wound around a respective arm of the magnetic core,
**characterized in that** this sensor comprises a printed circuit (4) in conformance with any one of the previous claims, the two coils of the printed circuit forming the two coils of the sensor.

9. An alternating voltage generator, this generator comprising:
- a succession of magnets (204) of opposite polarity, these magnets being placed beside one another in alternating polarities along a path of movement,
- a succession of coils (212) facing the succession of magnets, these coils being positioned beside one another along the path of movement in alternating winding directions, each coil being sized so as to be sensitive essentially to a magnetic field of a single magnet when the magnet faces this coil, this succession of coils being movable relative to the succession of magnets along the path of movement to generate an alternating voltage, and
- a printed circuit (214) comprising at least one metallization layer,
**characterized in that**:
- the coils (212) are grouped together in immediately adjacent pairs of coils along the direction of movement, the first and second coils (212B, 212A) of a same pair being formed by a same conductive track (216) wound in one direction around a first winding axis of the first coil (212B) and wound in an opposite direction around a second winding axis of the second coil (212A), this track being made in a first metallization layer of the printed circuit,
- the first coil (212B) is also formed by a second conductive track (218) made in another metallization layer of the same printed circuit, this second conductive track being wound in the same direction as the first conductive track (216) around the same first winding axis and being wound in an opposite direction around the winding axis of the second coil (212A) of the pair of coils immediately adjacent upstream, and
- the second coil (212A) is also formed by a third conductive track (218) made in another metallization layer of the same circuit, this third conductive track being wound in the same direction as the first conductive track around the same second winding axis and wound in an opposite direction around the winding axis of the first coil (212B) of the pair of coils immediately adjacent downstream, upstream and downstream being defined relative to the direction of movement.
